# EUROPEAN PATENT APPLICATION

(11) **EP 2 634 228 A2**
(43) Date of publication of application: **04.09.2013**
(21) Application number: 13157117.6
(22) Date of filing: 28.02.2013
(51) Int. Cl.: C09J 7/02

(54) **Self-rolling adhesive film**

(30) Priority: 29.02.2012 JP 2012044234
(71) Applicant: NITTO DENKO CORPORATION, Ibaraki-shi, Osaka 567-8680 (JP)
(72) Inventor: Kiuchi, Kazuyuki, Ibaraki-shi, Osaka 567-8680 (JP); Nishio, Akinori, Ibaraki-shi, Osaka 567-8680 (JP); Kawanishi, Michirou, Ibaraki-shi, Osaka 567-8680 (JP)
(74) Representative: Grünecker, Kinkeldey, Stockmair & Schwanhäusser

(57) **Abstract**

An easily detachable adhesive film, which is deformed into a cylindrical shape by heating to facilitate collection, fails to be sufficiently bonded to the surface of a workpiece, if the surface of the adhesive layer is roughened by the presence of irregularities. Because of this, when water penetrates in dicing, the adhesive layer peels off from the surface of the workpiece and may fail to achieve a surface-protection purpose. In addition, when the easily detachable adhesive film is deformed into a cylindrical shape by heating, detachment stress may not uniformly applied to a workpiece, with the result that the film cannot be smoothly deformed into a cylindrical shape; at the same time, a larger amount of glue remains in the surface of a workpiece than a conventional peel-detachment. A self-rolling adhesive film composed of a multi-layered substrate including at least one thermal contraction film, an adhesive layer and a separator, in which the surface of the adhesive layer after the separator is detached has an arithmetic average roughness Ra of 1.0 µm or less.

## Description

### BACKGROUND OF THE INVENTION

### Field of the Invention

The present invention relates to an adhesive film capable of deforming into a cylindrical shape by heating and maintaining the deformed shape.

### Description of the Related Art

If a release sheet for an adhesive film is smooth, the surface of the adhesive layer facing the release sheet becomes smooth. Such an adhesive film can bond airtight to a workpiece and sufficiently fulfill the function as an adhesive film, as described in Japanese Patent Laid-Open Nos. 2005-154689, 2002-363510 and 11-353709.
Up to present, the present inventors have developed easily detachable adhesive films using a laminate formed of a thermal contraction film layer, a bonding-agent layer (adhesive layer) and a rigid resin film layer as a substrate (Japanese Patent Laid-Open No. 2010-194819 and Japanese Patent No. 4151850).
This film is characterized in that contraction stress which is generated by heating the substrate is converted into torque in the laminate to detach the adhesive film from a workpiece as if the adhesive film is detached (peeled) by hand, and in that the adhesive film detached forms a cylindrical shape.
In order to put the film effectively into practical use, such cylindrical shaped pieces must be easily collected. More specifically, the cylindrical shaped pieces detached must maintain the cylindrical shape. This is because, to collect the cylindrically deformed film pieces by a practically useful method, collection by use of a detachment film, picking-up by a robot arm or the like and blowing-off by wind are conceivable (Japanese Patent Laid-Open No. 2011-54641); however, in any method, if cylindrical shaped pieces are easily deformed by application of stress of these collection operations, the adhesive film may attach again to a workpiece, with the result that it becomes difficult to collect the pieces.

In view of preventing a foreign matter from attaching to the surface of the adhesive layer of an adhesive film, it is usually desirable to provide a release sheet to the surface of the adhesive layer immediately before use of the adhesive film.
At this time, if the release surface of the release sheet is as smooth as possible, the surface of the adhesive layer after detachment of the release sheet can more strongly adhere to an object. In other words, since no irregularities are present on the surface of the adhesive layer, the adhesive layer can sufficiently strongly adhere to the surface of an object. For example, in the case where an adhesive film is used as a protection sheet for an object (workpiece) in a dicing step, since no water penetrates along a section line and no space is present between the object and the adhesive film, the adhesive film can achieve its purpose of protecting the object.
In the case where an adhesive layer is formed of an energy-ray curable resin, as long as no air bubbles are present in irregular portions of the surface of the adhesive layer, the adhesive layer can be sufficiently cured without causing curing failure.
In addition, since the surface of the adhesive layer is smooth, detachment stress is uniformly applied (without difference from place to place) when an adhesive film is detached from an object.
Likewise, the smoothness of surface of the adhesive layer can produce many effects; however, smoothness of the surface of the adhesive layer means that there is no knob for grabbing it in detaching in the ends of the adhesive film. As a result, it becomes extremely difficult to detach the adhesive film from the surface of an object processed.
Accordingly, if the surface of the adhesive layer is smooth, primarily no glue is left on the surface in detachment; however, glue is left depending upon the handling in detachment. In addition, when the adhesive film is removed from an object, the site of the object from which the film is detached may be damaged. Because of these, advantages of the smoothness of surface of the adhesive layer cannot be sufficiently obtained.
A conventional easily detachable adhesive film is deformed by heating into a cylindrical shape. Because of this, it is easy to collect it. However, if the surface of the adhesive layer is rough due to irregularities, the adhesive film cannot sufficiently adhere to the surface of a workpiece and water penetrates in dicing, with the result that the adhesive layer detaches from the surface of the workpiece and a purpose of protecting the surface may not be achieved.
Particularly, if the surface of the adhesive layer is rough due to irregularities, when an easily detachable adhesive film is heated to deform into a cylindrical shape, detachment stress may not be uniformly applied to a workpiece, with the result that deformation into cylindrical shape cannot be smoothly performed; at the same time, a larger amount of glue than that in usual detachment by peeling is left on the surface of the workpiece.

### SUMMARY OF THE INVENTION

1. A self-rolling adhesive film including a multi-layered substrate including a thermal contraction film, an adhesive layer and a separator, in which the surface of the adhesive layer after detachment of the separator has an arithmetic average roughness Ra of 1.0 µm or less.
2. The self-rolling adhesive film according to item 1, in which the separator has an arithmetic average roughness Ra of 1.0 µm or less and a detachment force of 1.0 N/50 mm or less.
3. The self-rolling adhesive film according to item 1, in which the thermal contraction film has a contraction percentage of 30 to 90% in the main contraction direction at a predetermined temperature within the range of 70 to 180°C.
4. The self-rolling adhesive film according to item 1, in which the multi-layered substrate includes a rigid film and the rigid film has a product obtained by multiplying the Young's modulus of the rigid film at 80°C and a thickness thereof of 3.0 × 10⁵ N/m or less.
5. The self-rolling adhesive film according to item 4, in which the thermal contraction film has a contraction percentage of 30 to 90% in the main contraction direction at a predetermined temperature within the range of 70 to 180°C and the product obtained by multiplying the Young's modulus of the rigid film at 80°C and a thickness thereof is 3.0 × 10⁵ N/m or less.
6. The self-rolling adhesive film according to any one of items 1 to 5, obtained by sequentially laminating the thermal contraction film, the bonding-agent layer, the rigid film, the adhesive layer and the separator in this order.
7. The self-rolling adhesive film according to any one of items 1 to 5, obtained by providing the adhesive layer on the separator and thereafter bonding the adhesive layer to the multi-layered substrate.
8. The self-rolling adhesive film according to any one of items 1 to 5, in which an organic coating layer is provided between the rigid film and the adhesive layer.
9. The self-rolling adhesive film according to any one of items 1 to 5, in which the adhesive layer is energy-ray curable or pressure-sensitive type.
10. The self-rolling adhesive film according to any one of items 1 to 5, in which detachment force (180° detachment by peeling, tension rate: 300 mm/minute) required for detachment between the thermal contraction film layer and the rigid film layer at 70°C is 2.0 N/10 mm or more.
11. A method for processing a workpiece, having a step of bonding the self-rolling adhesive film according to any one of items 1 to 10 to a workpiece, cutting the workpiece into small pieces, and heating to roll the self-rolling adhesive film, thereby detaching the self-rolling adhesive film from the workpiece.
12. The processing method according to item 11, in which the workpiece is a semiconductor wafer or a protecting member for an optical device.

According to the present invention, since the self-rolling adhesive film can sufficiently adhere to the surface of a workpiece, no air bubbles are present between an adhesive layer and the surface of the workpiece.
Because of this, even if the self-rolling adhesive film is immobilized to the surface of a workpiece by uniform adhesive force of the smooth surface adhesive layer, the self-rolling adhesive film is rolled by itself by heating after a processing step and detaches. Accordingly, it is not necessary for an operator to create a starting point of detachment and thus a workpiece cannot be damaged during the operation. Furthermore, since detachment stress is uniformly applied, self-rolling smoothly proceeds, with the result that the self-rolling adhesive film can be stably detached.
In addition, since air bubbles are not present as described above, no water penetrates between the adhesive layer and the surface of a workpiece in a dicing step. Even if the adhesive is energy-ray curable, the adhesive can be uniformly cured without causing curing failure. According to the present invention, a primary purpose of the film, that is, protecting a surface can be achieved without fail.

### BRIEF DESCRIPTION OF THE DRAWINGS

FIG. 1 is a sectional view of a film for constituting the adhesive film of the present invention;
FIG. 2 is a sectional view of the adhesive film of the present invention;
FIG. 3 shows an aspect of rolling the film and adhesive film of the present invention;
FIG. 4 shows an aspect of rolling the film and adhesive film of the present invention;
FIG. 5 shows rolling of the adhesive film of the present invention when it is used as a surface protective film in dicing;
FIG. 6 shows a conceptual view in returning a cylindrical shaped piece into an original flat film;
FIG. 7 shows a method for measuring a necessary load;
FIG. 8 is a photograph showing peel-off after dicing in Example 1; and
FIG. 9 is a photograph showing peel-off after dicing in Comparative Example 2.

### DETAILED DESCRIPTION OF THE PREFERRED EMBODIMENTS

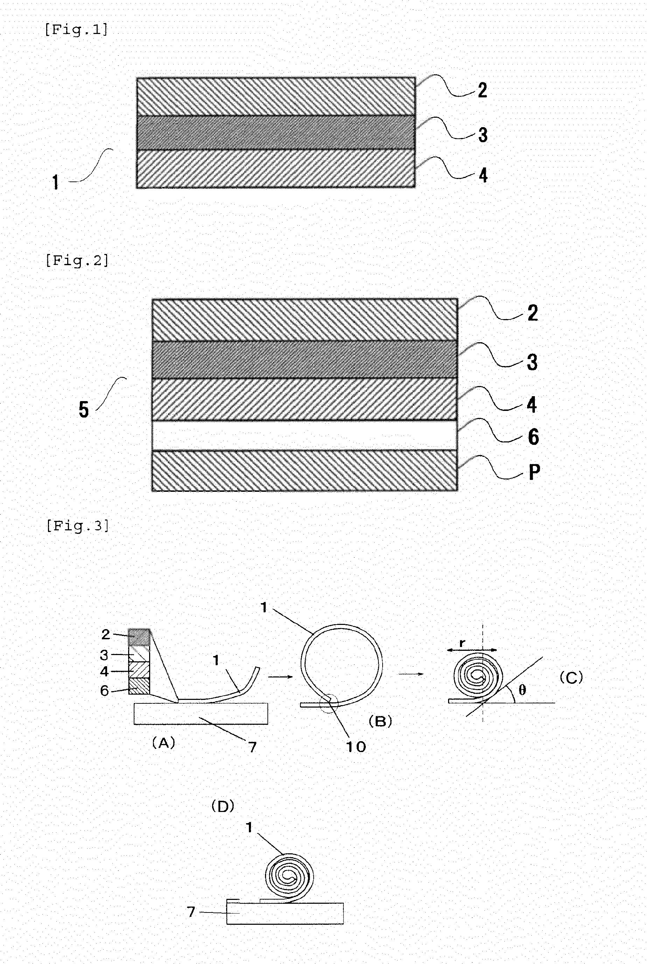

The present invention will be described below with reference to the accompanying drawings. FIG. 1 is a sectional view showing a film serving as a substrate for the self-rolling adhesive film of the present invention (hereinafter simply referred to as the "adhesive film"). FIG. 2 is a sectional view showing the self-rolling adhesive film of the present invention. In FIG. 1, a film 1 is prepared by laminating a thermal contraction film 2 having thermal contractility and a rigid film 4, which constrains contraction of the thermal contraction film 2, with a bonding-agent layer 3 interposed between them. Furthermore, in FIG. 2, an adhesive film 5 is prepared by laminating an adhesive layer 6 on the rigid film 4 of the film shown in FIG. 1. In this case, the film 1 serves as a support substrate for the adhesive film 5.

In the present invention, the self-rolling property refers to a property of rolling by itself by application of a stimulus such as heat without particularly requiring subsequent external force to form a roll. As the stimulus facilitating self-rolling, e.g., heat, light and electricity are mentioned; however, particularly heat is preferable. Note that the support film is preferably rolled by application of a stimulus such as heat to form a complete cylindrical roll (both ends overlap with each other); however, an incomplete cylindrical roll (both ends are not overlapped and a part of the cylinder is opened lengthwise) is acceptable as long as that the self-rolling adhesive film can achieve the object of the present invention.
The self-rolling occurs in accordance with the following mechanism: When a film having a contractive surface on one side is contracted, the film cannot be uniformly contracted and deforms into a cylindrical shape with the non-contractile surface exposed outside. The resultant cylindrical object has physical strength owing to the physical properties of the non-contractile material of the outer surface.

As the thermal contraction film 2, any film layer may be used as long as it has at least uniaxial contractility, and may be formed of e.g., a thermal contraction film, a photo contraction film or an electrical contraction film. Of them, a thermal contraction film is preferable in view of e.g., working efficiency. The thermal contraction film 2 may have uniaxial contractility or may have main contractility in a predetermined direction (uniaxial contractility) and additional contractility in a different direction (for example, the direction perpendicular to the predetermined direction). The thermal contraction film 2 may be formed of a single layer or multiple layers (consisting of 2 or more layers).

The contraction percentage of the thermal contraction film(s) forming the thermal contraction film 2 in the main contraction direction is preferably 30 to 90%. In the case where the thermal contraction film 2 is constituted of a thermal contraction film, the contraction percentage of the main contraction direction of the thermal contraction film at a predetermined temperature (for example, 95°C, 140°C) within the range of 70 to 180°C is preferably 30 to 900.

As the thermal contraction film, for example, a uniaxially drawn film formed of one or two or more types of resins selected from polyesters such as poly(ethylene terephthalate); polyolefins such as polyethylene and polypropylene, polynorbornene, polyimide, polyamide, polyurethane, polystyrene, poly(vinylidene chloride) and poly(vinyl chloride). Of them, since coating workability of a bonding agent is excellent, a uniaxially drawn film formed of a polyester resin, a polyolefin resin such as polyethylene, polypropylene and polynorbornene (including a cyclic polyolefin resin) or a polyurethane resin is preferable. As such a thermal contraction film, commercially available products such as "Space clean" manufactured by Toyobo Co., Ltd., "fancy wrap" manufactured by GUNZE LIMITED., "TORAYFAN" manufactured by Toray Industries Inc., "Lumilar" manufactured by Toray Industries Inc. "ARTON" manufactured by JSR Corporation, "ZEONOR" manufactured by ZEON CORPORATION and "SUNTEC" manufactured by Asahi Kasei Corporation can be used.
If such a drawn film is used, the self-rolling adhesive film contracted does not spontaneously return to an original shape. Needless to say, if the self-rolling adhesive film contracted is stretched so as to elongate, the shape of the self-rolling adhesive film becomes closer to an original planar shape. Based on the tensile force applied at this time, Young's modulus can be obtained.

Note that, in the case where the film 1 is used as a support substrate for the adhesive film 5 having the energy-ray curable adhesive layer 6, when the energy-ray curable adhesive layer is cured by irradiation of energy ray through the thermal contraction film 2, the thermal contraction film 2 needs to be formed of a material that can transmit a predetermined amount or more of energy ray (for example, a transparent resin).

The thickness of the thermal contraction film 2 is generally 5 to 300 µm and preferably 10 to 100 µm. If the thickness of the thermal contraction film 2 falls within the range, the film 1 dose not have excessively increased rigidity and can be deformed into a cylindrical shape. In addition, since the thermal contraction film 2 and the rigid film 4 are not separated, breakage of the film 1 does not occur. It is known that, in a highly rigid film, significant elastic deformation occurs due to remaining stress in bonding films and that warpage tends to be high when the thickness of a wafer is reduced. In order to enhance the adhesion property to an adjacent layer and retention ability, the surface of the thermal contraction film 2 may be treated with a conventional surface treatment such as a chemical or physical treatment including a chromic acid treatment, ozone exposure, flame exposure, high pressure electric shock exposure and ionization radiation treatment and a coating treatment with a sealer (for example, adhesive material).

The rigid film 4 constrains contraction of the thermal contraction film 2 to produce counteracting force. In this manner, torque of the entire film is produced and used as driving force of rolling. Furthermore, additional contraction is suppressed by the rigid film 4 from occurring in a different direction from the main contraction direction of the thermal contraction film 2. Thus, it is conceivable that the rigid film 4 has a function of converging contraction directions of the thermal contraction film 2 (contraction of which is said to occur uniaxially; however, actually, contraction may not always occur unidirectionally) into a single direction. Because of this, if a stimulus such as heat for facilitating contraction of the thermal contraction film 2 is applied to the film 1, repulsion force is produced in the rigid film 4 against contraction force of the thermal contraction film 2 and serves as driving force to lift up the outer peripheral portion of the film 1 (one end portion or two end portions facing each other). As a result, the film 1 rolls by itself from the end portion, with the thermal contraction film 2 inward, unidirectionally or toward the center (usually, along the main contraction axis of the thermal contraction film) to deform into a cylindrical shape. Moreover, shearing force produced by contraction deformation of the thermal contraction film 2 can be suppressed by the rigid film 4 from transmitting to the adhesive layer 6 and a workpiece. Thus, breakage of the adhesive layer 6 (for example, cured adhesive layer) reduced in adhesive force during re-detachment time, breakage of the workpiece, and contamination of the workpiece with the broken adhesive layer 6 can be prevented.

By providing the rigid film 4, when a stimulus such as heat causing contraction is applied to the thermal contraction film 2, a laminate sheet or an adhesive film can be smoothly self-rolled without stopping in the middle or without going off the direction to obtain a fine shaped cylindrical roll.
The product obtained by multiplying the Young's modulus of the rigid film layer and a thickness thereof (Young's modulus × thickness) is preferably 3.0 × 10⁵ N/m or less (for example, 1.0 × 10² to 3.0 × 10⁵ N/m) at the temperature (for example, 80°C) at which detachment occurs and further preferably 2.8 × 10⁵ N/m or less (for example, 1.0 × 10³ to 2.8 × 10⁵ N/m). Owing to this, a function of converting the contraction stress of the contractive film layer into rolling stress and function of converging the contraction directions can be ensured. In addition, owing to this, the rigid film layer is avoided to be excessively rigid and swift rolling can be facilitated with the help of the thickness of the aforementioned bonding-agent layer.
The Young's modulus of the rigid film layer is preferably 10 GPa or less at the temperature (for example, 80°C) at which detachment occurs and further preferably 5 GPa or less. If the Young's modulus falls within the range, self-rolling can be facilitated to obtain a fine-shaped cylindrical roll. Note that, the Young's modulus can be determined in accordance with e.g., the method described in JIS-K7127.
The thickness of the rigid film layer is suitably, e.g., about 5 to 100 µm and preferably about 8 to 50 µm. Owing to this, self-rolling properties can be ensured to obtain a fine-shaped cylindrical roll. Furthermore, handling and economic efficiency can be improved. It is preferred that the rigid film layer can be easily controlled in thickness in view of productivity and/or workability and is excellent in moldability and processability, in short, easily formed into a film.
Note that, as described later, as the adhesive layer of a self-rolling adhesive sheet, an energy-ray curable adhesive is suitably used. Since the energy-ray curable adhesive is cured by irradiation of energy ray through the rigid film layer, the rigid film layer is preferably formed of a material that can transmit a predetermined amount or more of energy ray (for example, a material that can transmit 90% or more, 80% or more or 70% or more of energy ray used such as a transparent resin).

Examples of the film constituting the rigid film 4 include films formed of one or two or more types of resins selected from polyesters such as poly (ethylene terephthalate), poly(butylene terephthalate) and poly(ethylene naphthalate); polyolefins such as polyethylene and polypropylene; polyimides; polyamides; polyurethanes; styrene resins such as polystyrenes; poly(vinylidene chloride); and poly(vinyl chloride) and others. Of them, since e.g., coating workability of an adhesive is excellent, polyester resin films, polypropylene films, polyamide films and others are preferable. The rigid film 4 may be a single layer or a multi-layer in which 2 or more layers are laminated. The film(s) constituting the rigid film 4 is non-contractility and the contraction percentage is, for example, 5% or less, preferably 3% or less and further preferably 1% or less.

Since the rigid film 4 constrains the contraction of the thermal contraction film 2, it has elastic adhesiveness (including stickiness). Furthermore, it is preferable that the rigid film 4 is more or less tough or rigid to smoothly form a cylindrical roll. The rigid film 4 may be formed of a single layer or a multi-layer whose function is shared by a plurality of layers.

In the examples shown in FIG. 1 and FIG. 2, the bonding-agent layer 3 is non-thermal contractive similarly to the rigid film 4.
The bonding-agent layer 3 is preferably deformable at a temperature at which the thermal contraction film 2 contracts (at a temperature at which the adhesive film detaches when a self-rolling laminate sheet is used as the support substrate of a self-rolling adhesive film) and more specifically, is in a rubber state. However, if the bonding-agent layer 3 is formed of a flowable material, sufficient counteracting force is not produced and ultimately a thermal contraction film contracts by itself and deformation (self-rolling) cannot occur. Accordingly, the bonding-agent layer 3 is preferably less flowable by means of e.g., a three-dimensional linkage. Furthermore, the thickness of the bonding-agent layer 3 contributes to standing against a weak component of nonuniform contraction force of the thermal contraction film 2 to prevent contraction deformation caused by the weak component of the force. In this manner, nonuniform contraction is changed into unidirectional contraction. After polishing a wafer, warpage occurs. This is conceivably caused by remaining stress in bonding the adhesive film to the wafer. More specifically, the remaining stress elastically deforms the thermal contraction film to cause warpage. The bonding-agent layer also serves to mitigate the remaining stress, thereby reducing warpage.

Accordingly, the bonding-agent layer 3 is desirably formed of a resin having adhesiveness and a glass transition temperature of, for example, 50°C or less, preferably room temperature (25°C) or less, and more preferably 0°C or less. The adhesive force of the surface of the bonding-agent layer 3 facing a thermal contraction film 2 preferably falls 0.5 N/10 mm or more in terms of value measured by 180° peel detachment test (performed in accordance with JIS Z 0237, tension rate: 300 mm/minute, 50°C). If the adhesive force falls within the range, no detachment occurs between the thermal contraction film 2 and the bonding-agent layer 3.
Furthermore, if the detachment force required for detachment between the thermal contraction film 2 and the rigid film 4 (180° peel strength at 70°C, tension rate: 300 mm/minute) is 2.0 N/10 mm or more and preferably 4.0 N/10 mm or more, the thermal contraction film 2 and the rigid film 4 are not separated throughout a rolling step.

Furthermore, the shearing storage elastic modulus G' of the bonding-agent layer 3 is preferably 1 × 10⁴ Pa to 5 × 10⁶ Pa (particularly, 0.05 × 10⁶ Pa to 3 × 10⁶ Pa) at a temperature from room temperature to the temperature at which detachment occurs (for example, 80°C).
The higher the shearing storage elastic modulus, the easier the contraction force is converted into torque. However, if the elastic modulus is excessively high, it becomes difficult to deform into a cylindrical shape by torque. The thickness of the bonding-agent layer 3 should be determined based on the thickness at which adhesion force is sufficiently produced; however, the thickness is preferably about 0.01 to 150 µm and more preferably about 0.1 to 10 µm. If the thickness falls within the range, deformability to a cylindrical shape is maintained and handling and economic efficiency are excellent.

Furthermore, the bonding-agent layer 3 is formed of a material through which an energy ray easily transmits in the case where the adhesive layer 6 is an energy-ray curable adhesive layer. In view of e.g., productivity and workability, a material having excellent moldability (i.e., easily formed into a film) and processability and capable of appropriately controlling the thickness of the resultant film is preferable.

As the bonding-agent layer 3, for example, a resin film such as a non-expandable resin film (including a sheet) formed of a material such as a rubber and a thermoplastic elastomer can be used. Examples of the adhesive for use in an adhesive treatment include, but not particularly limited to, known adhesives such as an acrylic adhesive, a rubber adhesive, a vinylalkyl ether adhesive, a silicone adhesive, a polyester adhesive, a polyamide adhesive, a urethane adhesive and a styrene-diene block copolymer adhesive. These can be used alone or in combination with two or more types. Particularly, in view of controlling adhesive force, an acryl adhesive is preferably used. Furthermore, a laminated bonding-agent layer formed of e.g., a urethane bonding agent or a polyester bonding agent can be employed.

The above acrylic adhesive is composed of an acrylic adhesive containing an acrylic polymer as a base polymer and a crosslinking agent serving as an additive. Examples of the acrylic polymer include mono or copolymers of esters of a (meth)acrylic acid and an alkyl such as an ester of a C₁-C₂₀ alkyl and (meth)acrylic acid including methyl (meth)acrylate, ethyl (meth)acrylate, butyl (meth)acrylate, 2-ethylhexyl (meth)acrylate, octyl (meth)acrylate; and copolymers of an ester of (meth)acrylic acid and an alkyl and another copolymerizable monomer [for example, a carboxyl group-or acid anhydride group-containing monomer such as acrylic acid, methacrylic acid, itaconic acid, fumaric acid and maleic anhydride; a hydroxyl group-containing monomer such as 2-hydroxyethyl (meth)acrylate; an amino group-containing monomer such as morpholyl (meth)acrylate; an amide group-containing monomer such as (meth)acrylamide; a cyano group-containing monomer such as (meth)acrylonitrile; and an alicyclic hydrocarbon group-containing (meth)acrylate such as isobornyl (meth)acrylate].

An acrylic polymer can be produced by a known polymerization method, for example, thermal polymerization of a monomer component as mentioned above (and a polymerization initiator) in a solvent and photopolymerization of a monomer component as mentioned above (and polymerization initiator) by light (UV rays) in the absence of a solvent.

Examples of the crosslinking agent include, but not particularly limited to, isocyanate crosslinking agents, melamine crosslinking agents and epoxy crosslinking agents. Other than these, UV-ray (UV) reactive crosslinking agent using e.g., an isocyanate group-containing (meth)acrylate may be used. The addition amount of crosslinking agent is usually about 0.01 to 15 parts by weight and preferably about 0.05 to 12 parts by weight based on the above base polymer (100 parts by weight).

The acrylic adhesive may contain, other than a base polymer and a crosslinking agent, appropriate additives such as a cross-linking promoter, an adhesiveness imparting agent (for example, a rosin derivative resin, a polyterpene resin, a petroleum resin, an oil soluble phenol resin), a thickener, a plasticizer, a filler, an age resister and an antioxidant.

In the bonding-agent layer 3, for example, a crosslinkable acrylic adhesive described in e.g., Japanese Patent Laid-Open No. 2008-155619 and a bonding agent for lamination such as a polyester bonding agent including VYLON manufactured by Toyobo Co., Ltd. can be used; however, in view of workability or the like, a urethane adhesive used as a dry laminate bonding agent is preferable.
The urethane adhesive is a bonding agent in which a compound having an isocyanate group as a functional group and a compound having a hydroxyl group are mixed to produce a urethane bond through a chemical reaction. Since the urethane bond has strong hydrogen bindability, intermolecular interaction with a molecule to be bonded is strong. Thus, the urethane bonding agent is particularly preferable for bonding a film formed of a polar material. Furthermore, since the intermolecular force between bonding agent molecules is strong, even if the bonding agent is heated, softening rarely occurs. Thus, dependency upon temperature is low.
As the urethane adhesive, a urethane adhesive using an aliphatic urethane having high heat stability is preferable. Furthermore, a urethane adhesive having a rigid cyclic skeleton in combination with a flexible skeleton mainly responsible for bending a molecular chain, such as an ether bond or an ester bond, is preferable.
Specifically, Takerak (registered trade mark) or Takenate (registered trade mark) or the like manufactured by Mitsui Chemicals, Inc., Seika bond (registered trade mark) or the like manufactured by Dainichiseika Color & Chemicals, Mfg. Co., Ltd. and TM569 or the like manufactured by Toyo-Morton, Ltd., can be used.

The above urethane adhesive may be used in combination with a curing accelerator. Organic metal compounds formed of tin, titanium and zirconium and an amine curing accelerator are preferable.
Specific examples of the amine curing accelerator include triethylamine, triethylenediamine, tetramethyl-1,3-butanediamine, ethylmorpholine, diazabicycloundecene and diazabicyclononene. The addition amount of the curing accelerator is 0.001 to 5wt % relative to the urethane prepolymer. If the addition amount falls within the range, the urethane adhesive has appropriate strength and a pot life is not shortened.

The urethane adhesive, similarly to the aforementioned acrylic adhesive, may contain, other than a cross-linking promoter, appropriate additives such as an adhesive imparting agent (for example, a rosin derivative resin, a polyterpene resin, a petroleum resin, an oil soluble phenol resin), a thickener, a plasticizer, a filler, an age resistor and an antioxidant.

Separator P is a layer to be formed on the adhesive layer 6 and used for protecting the surface of the adhesive layer 6 from dirt and others. In addition, in the present invention, the surface roughness of the detachment surface of separator P in contact with the surface of the adhesive layer has an arithmetic average roughness Ra of 1.0 µm or less, preferably 0.70 µm or less and further preferably 0.50 µm or less.
If the surface roughness falls within the range, the surface shape of the adhesive layer 6, on which the surface shape of the detachment surface of the separator is reflected, is sufficiently smooth (an arithmetic average roughness Ra of 1.0 µm or less). The arithmetic average roughness Ra of the adhesive-layer surface thus obtained is preferably 0.70 µm or less and further preferably 0.40 µm or less. In the present invention, if the arithmetic average roughness Ra of the surface of the adhesive layer is 1.0 µm or less, surfacing does not occur in dicing and the amount of remaining glue can be reduced after detachment by rolling as well as remaining glue (measured in terms of number of particles) after detachment by hand can be reduced.
The lower limit of Ra is not particularly limited; however, in consideration that the surface is desirably as smooth as possible, the most preferable Ra value (ideal value) is 0 µm. In view of technical achievability, Ra is 0.0001 µm or more. This is conceivably useful in the present invention.
Hereinafter, the arithmetic average roughness of each of the separator surface and the adhesive-layer surface is simply referred to as a surface roughness or Ra.
Owing to this, the self-rolling adhesive film, when it is bonded to the surface of a workpiece, can sufficiently protect the surface. When the resultant workpiece is cut in dicing, a space that allows water or the like to penetrate is not formed between the workpiece surface and the adhesive-layer surface.
Even if the self-rolling adhesive film is rolled after processing, since the adhesive force applied to the workpiece surface is uniform, the amount of remaining glue on the workpiece surface after detachment reduces.

Separator P may be formed of a substrate film formed of one or more drawn or undrawn layers. A release-agent layer may be provided on one of the surfaces of the substrate film.

In the case of separator P having no release-agent layer (in short, formed of a substrate film alone), the layer of separator P at least in contact with the adhesive layer 6 is formed of a resin composition having a low surface free energy, and more specifically, is a resin film formed of at least one or two or more elements selected from polyesters such as poly(ethylene terephthalate), poly(butylene terephthalate) and poly(ethylene naphthalate); polyolefins such as polyethylene and polypropylene, polyimide; polyamide; polyurethane, styrene resins such as polystyrene, poly(vinylidene chloride); and poly(vinyl chloride). Of them, since coating workability of an adhesive is excellent, e.g., a polyester resin film, a polypropylene film, and a polyamide film are preferable.

In the case of separator P with a release-agent layer (in short, separator P consisting of a substrate film and a release-agent layer), one of the surfaces of the film 4 formed of a paper such as high quality paper, Clupak, glassine and crepe, a polyester such as poly(ethylene terephthalate), poly(butylene terephthalate) and poly(ethylene naphthalate), polypropylene, polyethylene or an ethylene-α-olefin copolymer is coated with a silicone compound such as dimethylsiloxane and diphenylsiloxane, a silicone resin, a fluorine resin or a long-chain alkyl compound such as ASHIO RESIN; or a layer formed of a composition of these resins can be laminated. Furthermore, if necessary, the resin composition layer may be coated with a release agent such as a silicone compound.

In addition, the release-agent layer can be formed by treating the substrate film with a plasma or corona discharge in an atmosphere of a fluorine atom-containing substance or a silicon compound.
The release-agent layer is preferably formed by uniformly applying a release agent on the surface of the substrate film to have uniform surface free energy. This is because if the surface free energy is nonuniform, the detachment stress when separator P is detached from the adhesive layer 6 becomes nonuniform, with the result that an adhesive drops off from the adhesive layer 6, increasing the surface roughness of the adhesive layer 6.
The detachment force of Separator P thus obtained from the adhesive layer 6 is preferably 1.0 N/50 mm or less. If the detachment force falls within the range, in the self-rolling adhesive film of the present invention, the separator can be smoothly detached from the adhesive layer 6. Thus, the adhesive layer 6 having a smooth surface (a surface roughness of 1.0 µm or less) can be used.

The thickness of the release-agent layer can be arbitrarily selected within the range required for providing sufficient release properties. Similarly, the thickness of the substrate film may be selected within the range in which the substrate film can sufficiently serve as a substrate for separator P and is excellent in handling ability.
In order to obtain a surface roughness within the above range, a film is formed of a resin as mentioned above or the film thus formed is further drawn. If the aforementioned surface roughness can be obtained in this manner, other means is not required. However, to further reduce the surface roughness or in the cases where a resin which is hardly smoothened is used, it is required to employ a pressurizing operation, for example, pressurizing both surfaces of a substrate film by e.g., a smooth pressurization roller during substrate film formation time.

As shown in FIG. 3, the self-rolling adhesive film of the present invention is rolled with application of a stimulus such as heating.
FIG. 3A shows a stage at which an end portion of the self-rolling adhesive film bonded to the surface of a workpiece starts detaching from the surface of the workpiece in the beginning of rolling and bends backward. The end portion that bends backward is going to roll by contraction of the thermal contraction film.
The self-rolling adhesive film makes one round by rolling. This state is taken out as FIG. 3B and will be described. In the stage shown in the figure, as the self-rolling adhesive film rolls, the section of the edge portion makes a circle. A part of the self-rolling adhesive film is still bonded to the surface of a workpiece or almost completely detached and the leading end portion of the thermal contraction film is just in contact with the back surface of the self-rolling adhesive film, i.e., thermal contraction film.
The point at which self-rolling adhesive film is in contact with the back surface thereof is represented by a contact point 10. One round of a roll of the self-rolling adhesive film is ended at the contact point 10.

Thereafter, the leading end of the self-rolling adhesive film moves forwards by subsequent rolling movement and slips along the back surface of the layer formed of a thermal contraction film of the self-rolling adhesive film. The contact point 10 moves and the leading end portion continuously moves inside by rolling. In this manner, as rolling proceeds, the cylindrical roll of the self-rolling adhesive film is made compact so as to reduce the outer diameter r.
As a result, as shown in FIG. 3C, the outer diameter r of a cylindrical-shaped self-rolling adhesive film formed by thermal contraction on the surface of a workpiece reduces and the detachment angle θ formed between the surface of a workpiece and the self-rolling adhesive film increases as a detachment process proceeds by rolling of the self-rolling adhesive film off from the surface of a workpiece.
By virtue of this, the detachment stress applied to the workpiece decreases to avoid breakage of a fragile workpiece.

Rolling proceeds and reaches the stage shown in FIG. 3D, in which the surface area of the self-rolling adhesive film is small. Thus, heat is rarely emitted from the self-rolling adhesive film heated. Since heat is kept inside the self-rolling adhesive film and the temperature once increased tends to be maintained, contraction easily proceeds. As a result, rolling further proceeds and the outer diameter tends to reduce.

As the adhesive layer 6, an adhesive layer originally having low adhesive force or a bonding-agent layer having low adhesive force can be used. In either case, it is preferable that the adhesive layer 6 has adhesiveness capable of bonding to a workpiece, and that after a predetermined role is completed, the adhesiveness of the adhesive layer 6 can be reduced or disappear by some treatment (adhesiveness reduction treatment). In short, the adhesive layer is preferably re-detachable. Such a re-detachable adhesive layer can be formed in the same manner as the adhesive layer of a known re-detachable adhesive film. In view of self-rolling property, an adhesive force (peel and detach at 180° from a silicon mirror wafer, tension rate: 300 mm/minute) of the adhesive layer or the adhesive layer to which the adhesive reduction treatment is applied is desirably, for example, 50 N/10 mm or less at normal temperature (25°C), preferably 25 N/10 mm or less and more preferably 10 N/10 mm or less.

As the adhesive layer 6, particularly an energy-ray curable adhesive layer is preferable. The energy-ray curable adhesive layer can be formed of a material having adhesiveness in the beginning and capable of forming a three dimensional network structure by irradiation with an energy ray such as infrared rays, visible rays, UV rays, X-rays and electron beams to change into a highly elastic material. As such a material, e.g., an energy-ray curable adhesive can be used. The energy-ray curable adhesive contains a compound chemically modified with an energy-ray reactive functional group for imparting energy-ray curability or an energy-ray curable compound (or energy-ray curable resin). Accordingly, the energy-ray curable adhesive constituted of a composition containing a base agent chemically modified with an energy-ray reactive functional group or a base agent to which an energy-ray curable compound is added is preferably used.

As the base agent, an adhesive material such as a conventionally known pressure sensitive bonding agent (adhesive) can be used. Examples of the adhesive include rubber adhesives using a rubber polymer such as a natural rubber, polyisobutylene rubber, styrene-butadiene rubber, styrene-isoprene-styrene block copolymer rubber, regenerated rubber, butyl rubber, polyisobutylene rubber and NBR, as a base polymer; a silicone adhesive; and an acrylic adhesive. Of them, an acrylic adhesive is preferable. The base agents may be constituted of a single component or two or more components.

Examples of the acrylic adhesive include acrylic adhesives using an acrylic polymer such as mono or copolymers of esters of a (meth)acrylic acid and an alkyl including an ester of a C₁-C₂₀ alkyl and (meth)acrylic acid including methyl (meth)acrylate, ethyl (meth)acrylate, butyl (meth)acrylate, 2-ethylhexyl (meth)acrylate, and octyl (meth)acrylate; and copolymers of an ester of (meth)acrylic acid and an alkyl and another copolymerizable monomer [for example, a carboxyl group- or acid anhydride group-containing monomer such as acrylic acid, methacrylic acid, itaconic acid, fumaric acid and maleic anhydride; a hydroxyl group-containing monomer such as 2-hydroxyethyl (meth)acrylate; an amino group-containing monomer such as morpholyl (meth)acrylate; and an amide group-containing monomer such as (meth)acrylamide], as a base polymer. These can be used alone or in combination with two or more types.

The energy-ray reactive functional group and energy-ray curable compound to be used in chemical modification for curing an energy-ray curable adhesive with an energy ray are not particularly limited as long as they can be cured with an energy ray such as infrared rays, visible rays, UV rays, X-rays and electron beams; however, the functional group and compound capable of effectively mediating three-dimensionally reticulation (networking) of the energy-ray curable adhesive with irradiation of an energy ray are preferable. These can be used alone or in combination with two or more types. Examples of energy-ray reactive functional group for use in chemical modification include functional groups having a carbon-carbon multiple bond such as an acryloyl group, a methacryloyl group, a vinyl group, an allyl group and an acetylene group. When these functional groups are irradiated with an energy ray, a carbon-carbon multiple bond is cleaved to produce radicals, which serve as crosslinking points for producing three-dimensional network structure. Of them, a (meth)acryloyl group is preferable in view of reactivity and workability since a (meth)acryloyl group can be highly reactive to an energy ray and (meth)acryloyl groups can be selected from many types of acrylic adhesives and used in combination.

Typical examples of a base agent chemically modified by an energy-ray reactive functional group include a polymer obtained by reacting a compound [e.g., (meth)acryloyloxyethylene isocyanate], which has a group reactive with the reactive functional group (e.g., an isocyanate group, an epoxy group) and an energy-ray reactive functional group (e.g., an acryloyl group, a methacryloyl group) within a molecule with a reactive functional group-containing acrylic polymer, which is obtained by copolymerizing a monomer containing a reactive functional group such as a hydroxyl group and a carboxyl group [for example, 2-hydroxyethyl (meth)acrylate, (meth)acrylate] with an ester of a (meth)acrylic acid and an alkyl.

In the reactive functional group-containing acrylic polymer, the ratio of the monomer containing a reactive functional group is for example 0.01 to 100 wt% relative to all monomers. In reacting with the reactive functional group-containing acrylic polymer, the use amount of compound which has a group reactive with a reactive functional group and an energy-ray reactive functional group within a molecule is, for example, 1 to 100 mole % and preferably 20 to 95 mole% relative to reactive functional group (hydroxyl group, carboxyl group and others) in the reactive functional group-containing acrylic polymer.

Examples of the energy-ray curable compound include an ester having a (meth)acryloyl group at a molecular end such as a (meth)acrylate, a urethane (meth)acrylate, an epoxy (meth)acrylate, a melamine (meth)acrylate and an acrylic resin (meth)acrylate, thiol-ene additional type resin having an allyl group at a molecule end and a photo cation polymerizable resin, a cinnamoyl group-containing polymer such as polyvinyl cinnamate, and a photosensitive reactive group-containing polymer or oligomer such as a diazotized amino novolak resin and an acrylamide polymer. Furthermore, examples of a polymer which becomes reactive with irradiation of a high energy ray include an epoxylated polybutadiene, an unsaturated polyester, a polyglycidyl methacrylate, a polyacrylamide and poly(vinyl siloxane).
Furthermore, examples of a polymer reacting with a high energy ray include compounds having two or more carbon-carbon double bonds such as poly (meth)acryloyl group-containing compounds including trimethylolpropane triacrylate, tetramethylolmethane tetraacrylate, pentaerythritol triacrylate, pentaerythritol tetraacrylate, dipentaerythritol monohydroxy pentaacrylate, dipentaerythritol hexaacrylate, 1,4-butanediol diacrylate, 1,6-hexanediol diacrylate and polyethylene glycol diacrylate. These compounds may be used alone or in combination with two or more types. Of them, a poly (meth)acryloyl group-containing compound is preferable. This is exemplified, for example in Japanese Patent Laid-Open No. 2003-292916. Hereinafter, the poly (meth)acryloyl group-containing compound will be sometimes referred to as an "acrylate crosslinking agent".
Furthermore, as the energy-ray curable compound, for example, a mixture of an organic salt such as an onium salt and a compound having a plurality of heterocyclic rings in a molecule can be used. When the mixture is irradiated with an energy ray, an organic salt is cleaved to produce ions, which serve as an initiation seed for inducing a ring-opening reaction of a heterocyclic ring to form a three-dimensional network structure. Examples of the organic salt include an iodonium salt, a phosphonium salt, an ammonium salt, a sulfonium salt and a borate salt. Examples of the heterocyclic ring in the compound having a plurality of heterocyclic rings in a molecule include oxirane, oxetane, oxolane, thiirane and aziridine. Specifically, the compounds described in Photo-Setting Technology (2000) edited by Technical Information Institute Co., Ltd., can be used.
Note that, if an energy-ray curable compound is used, the aforementioned base agent is not always necessary.

As the energy-ray curable adhesive, an adhesive, which is prepared from an acrylic polymer as mentioned above or an acrylic polymer chemically modified with an energy-ray reactive functional group (an acrylic polymer having an energy-ray reactive functional group introduced in a side chain) in combination with an energy-ray curable compound (e.g., a compound having two or more carbon-carbon double bonds) as mentioned above, is particularly preferable. The combination contains an acrylate group showing a relatively high reactivity to an energy ray and, in addition, can be selected from various types of acrylic adhesives. Thus, the combination is preferable in view of reactivity and workability. Specific examples of such a combination include a combination of an acrylic polymer having an acrylate group introduced in a side chain and a compound having two or more functional groups (particularly, an acrylate group) having a carbon-carbon double bond. As such a combination, those disclosed in e.g., Japanese Patent Laid-Open No. 2003-292916 can be used.

As a method for preparing the acrylic polymer having an acrylate group introduced in a side chain, for example, a method of binding an isocyanate compound, such as acryloyloxyethyl isocyanate and methacryloyloxyethyl isocyanate, to an acrylic polymer having a hydroxyl group in a side chain via a urethane bond can be used.

The content of the energy-ray curable compound falls, for example, within the range of about 0.001 to 500 parts by weight, preferably 0.01 to 200 parts by weight and further preferably about 0.1 to 150 parts by weight relative to 100 parts by weight of the base agent (e.g., an acrylic polymer as mentioned above, an acrylic polymer chemically modified with an energy-ray reactive functional group).

To the energy-ray curable adhesive, an energy-ray polymerization initiator for curing an energy-ray curable compound may be blended in order to improve the rate of a reaction for forming a three dimensional network structure.

As the energy-ray polymerization initiator, a known or conventional polymerization initiator can be appropriately selected depending upon the type of energy ray to be used (for example, infrared rays, visible rays, ultraviolet rays, X-rays, electron beams). In view of working efficiency, a compound capable of initiating a photopolymerization with UV rays is preferable. Examples of a typical energy-ray polymerization initiator include, but not limited to, ketone initiators such as benzophenone, acetophenone, quinone, naphthoquinone, anthraquinone and fluorenone; azo initiators such as azobisisobutyronitrile; and peroxide initiators such as benzoyl peroxide and perbenzoate. As a commercially available product, for example, "IRGACURE 184" and "IRGACURE 651" (trade names manufactured by BASF) are mentioned.

Energy-ray polymerization initiators can be used alone or in combination with two or more types. The content of the energy-ray polymerization initiator is usually about 0.01 to 10 parts by weight and preferably about 1 to 8 parts by weight relative to the above base agent (100 parts by weight). Note that, if necessary, an energy-ray polymerization accelerator may be used in combination with the energy-ray polymerization initiator.

To an energy-ray curable adhesive, other than the aforementioned components, appropriate additives such as a cross-linking agent, a curing (crosslinking) accelerator, an adhesion imparting agent, vulcanization agent and a thickener to obtain appropriate adhesiveness before and after curing with an energy ray, and appropriate additives such as an age resistor and an antioxidant to improve durability, are blended, if necessary.

Furthermore, as an adhesive constituting the adhesive layer 6, a non energy-ray curable adhesive containing an acrylic adhesive as mentioned above as a base agent can be used. In this case, the adhesive having a smaller adhesive force than detachment stress required for forming a cylindrical roll is available. For example, an adhesive having an adhesive force of 50 N/10 mm or less, preferably 25 N/10 mm or less and more preferably 10 N/10 mm or less, (as measured in a 180° peel detachment test (room temperature (25°C)) using a silicon mirror wafer as a workpiece) can be used.

As the non energy-ray curable adhesive containing an acrylic adhesive having a small adhesive force as a base agent, it is preferable to use an acrylic adhesive, which is prepared by adding a crosslinking agent capable of reacting with a reactive functional group [e.g., an isocyanate crosslinking agent, a melamine crosslinking agent, an epoxy crosslinking agent] to a copolymer, which is prepared by an ester of a (meth)acrylic acid and an alkyl [for example, an ester of (meth)acrylic acid and a C₁-C₂₀ alkyl, such as methyl (meth)acrylate, ethyl (meth)acrylate, butyl (meth)acrylate, 2-ethylhexyl (meth)acrylate and octyl (meth)acrylate], a monomer having a reactive functional group [for example, a carboxyl group or acid anhydride group-containing monomer such as acrylic acid, methacrylic acid, itaconic acid, fumaric acid and maleic anhydride; a hydroxyl group-containing monomer such as 2-hydroxyethyl (meth)acrylate; an amino group-containing monomer such as morpholyl (meth)acrylate; and an amide group-containing monomer such as (meth)acrylamide] and another optional copolymerizable monomer [for example, (meth)acrylate having an alicyclic hydrocarbon group such as isobornyl (meth)acrylate, and acrylonitrile] and crosslinking them.

The adhesive layer 6 is formed, for example, by a conventional method such as a method of applying a coating liquid, which is prepared by adding an adhesive, an energy-ray curable compound and an optional solvent, to a surface of the rigid film 4, and a method of applying the coating liquid to a detachment liner (separator) to form an adhesive layer and transferring the adhesive layer onto the rigid film 4. In the transferring method, voids may sometimes remain in the interface with the rigid film 4. In this case, a heating/pressurizing treatment is applied by e.g., an autoclave to disperse voids away. The adhesive layer 6 may be either a single layer or a multi-layer.

Furthermore, a coating method is important to control the arithmetic average roughness Ra of the adhesive layer 6 to be 1.0 µm or less.
The coating method should be arbitrarily selected depending upon the viscosity of a coating adhesive and a desired thickness. For example, a known coating method such as a gravure coater, a reverse gravure coater, a bar coater, a comma coater and a die coater may be used. However, if air bubbles are contained in the adhesive solution applied, they become a cause of increasing the surface roughness of the resultant adhesive layer. Care must be taken. In this case, air bubbles can be removed by passing the adhesive solution through a filter before coating. In view of this, air-tight die system is preferably used.
Furthermore, it is important to suppress static electricity of a film when it is coated with an adhesive solution. This is because if a substrate film is electrically charged by detachment of a substrate film or abrasion with a pass line roll, the adhesive solution is electrically repelled due to dielectric polarization. As the result, the surface roughness of the adhesive layer increases. Accordingly, it is important to take a measure such as discharging by discharge cloth, charge neutralization by an ionizer and prevention of static charge by humidification before application of the adhesive solution.
When an adhesive is dissolved in a solvent and applied to form an adhesive layer 6, solvent drying conditions such as drying temperature and a coating line rate are important. This is because, for example, if drying is performed at a temperature of not less than a boiling point of a solvent, the solvent vigorously volatilizes from the surface of the adhesive surface, increasing the surface roughness of the adhesive layer. In this case, even if separator P having an arithmetic average roughness Ra of 1.0 µm or less is used, it is impossible to smoothen the surface of the adhesive layer. Accordingly, it is preferable that the adhesive layer is dried at not more than the boiling point of a solvent in advance, and thereafter, subjected to a main drying process performed at a temperature of the boiling point or more.

The thickness of the adhesive layer 6 is generally 1 to 200 µm, preferably 20 to 100 µm and further preferably 30 to 60 µm. If the thickness falls within the above range, the adhesive layer can acquire sufficient adhesive force to hold and provisionally immobilize a workpiece. This is excellent and favorable in view of economy and handling.

The self-rolling adhesive film of the present invention can be manufactured by laminating the thermal contraction film 2 and the rigid film 4, on which an adhesive layer 6 provided with a detachment liner is formed, with the bonding-agent layer 3 interposed between them. At this time, a laminating means such as a hand roller and a laminator and an atmospheric pressure compression means such as an autoclave can be appropriately and optionally used in accordance with the purpose. Alternatively, the self-rolling adhesive film of the present invention can be manufactured by forming the adhesive layer 6 on the rigid film 4, which is laminated on the thermal contraction film 2 via the bonding-agent layer 3.
Furthermore, the adhesive film of the present invention can be manufactured by providing the adhesive layer 6 on the surface of the rigid film 4 of the self-rolling laminate film or laminating the rigid film 4, on which the adhesive layer 6 is previously provided on one of the surfaces thereof, on the thermal contraction film 2 via the bonding-agent layer 3.

The adhesive film 5 of the present invention can be used, for example, as an adhesive film for protecting e.g., a semiconductor and an adhesive film for immobilizing e.g., a semiconductor wafer. The adhesive film 5 of the present invention is more specifically used as e.g., an adhesive film for back-grinding a silicone semiconductor, an adhesive film for back-grinding a compound semiconductor, an adhesive film for dicing a silicon semiconductor, an adhesive film for dicing a compound semiconductor, an adhesive film for dicing a semiconductor package, an adhesive film for dicing glass and an adhesive film for dicing ceramic; and particularly, useful as an adhesive film for a semiconductor such as an adhesive film for protecting a semiconductor and an adhesive film for immobilizing a semiconductor wafer.

Next, a method for processing a workpiece by use of the adhesive film of the present invention will be described. The adhesive film of the present invention is bonded to a workpiece to provisionally immobilize thereto. After a predetermined process is applied to the workpiece, the adhesive force of the adhesive layer of the adhesive film is lowered; at the same time, heat or the like is applied for contracting a thermal contraction film to allow the adhesive film to roll by itself unidirectionally (usually, along the main contraction axis) from an end of the adhesive film or from two ends facing each other toward the center (usually, along the main contraction axis) into one or two cylindrical shapes. In this way, the adhesive film is detached from the workpiece to obtain a processed product. Note that, when deformation takes place unidirectionally from an end of the adhesive film, a single cylindrical shape is formed (unidirectional rolling detachment). When self-rolling takes place from two ends facing each other of an adhesive film toward the center, two cylindrical shapes arranged in parallel next to each other are formed (bidirectional rolling detachment).

Typical examples of the workpiece include a semiconductor wafer formed of a compound such as silicon and GaAs and optical parts such as a filter, glass and quartz. Examples of the processing include grinding, cutting, polishing, etching, turning process and heating (however, if a contraction film is a thermal contractive film, the temperature is limited to a thermal contraction initiation temperature or less). The type of processing is not particularly limited as long as it can be applied to the adhesive film.

After processing of a workpiece, if e.g., an energy-ray curable adhesive layer is used as an adhesive layer, the adhesive layer is irradiated with an energy ray; at the same time, a thermal contraction film is heated by a predetermined heating means. As a result, the adhesive layer is cured and loses adhesive force and the thermal contraction film is going to contract and deform. Consequently, the outer edge portion of the adhesive film lifts up and starts to roll (or two ends facing each other start to roll). The adhesive film rolls unidirectionally by itself (or rolls in two mutually opposite directions (center direction)) to form a single cylindrical shape (or two cylindrical shapes). In this time, while the adhesive film can be controlled in contraction direction by a rigid film, the adhesive layer unidirectionally is rolled to immediately form a cylindrical shape. In this manner, the adhesive film can be extremely easily and finely detached from the workpiece. The heating temperature, which can be appropriately selected depending upon the contractility of a thermal contraction film, is, for example, 70 to 180°C and preferably 70 to 140°C. Irradiation of an energy ray and heat treatment may be performed simultaneously or stepwise. Furthermore, the surface of a workpiece can be wholly heated uniformly or stepwise. Furthermore, heating may be applied to a part of the surface just to trigger detachment. Heating treatment should be appropriately selected depending upon the purpose for taking advantage of easy-to-peel properties.

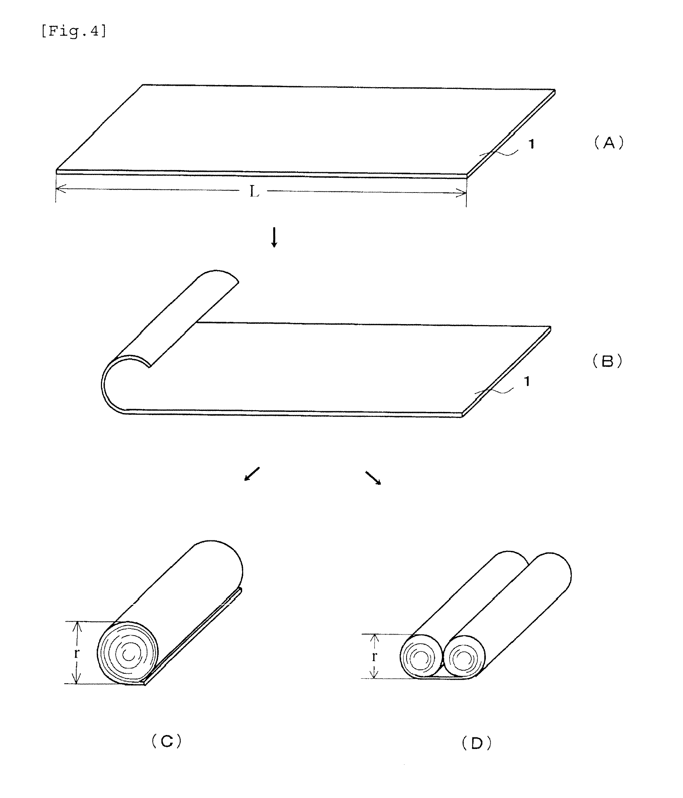

FIG. 4 is a (prospective) view showing how to deform the self-rolling adhesive film of the present invention into a cylindrical shape. FIG. 4A shows a self-rolling adhesive film before a stimulus is applied, which causes contraction of the self-rolling adhesive film. FIG. 4B shows the state where the self-rolling adhesive film (the adhesive force of the adhesive layer thereof is lowered or disappears), which has been stimulated by a stimulus causing contraction of the self-rolling adhesive film, starts to unidirectionally (usually, in the main contraction axis direction of the self-rolling adhesive film) roll from the outer edge portion thereof (one end portion). FIG. 4C shows that the rolling of the self-rolling adhesive film is completed to form a single cylindrical shape (unidirectional rolling).
FIG. 4D shows the state where the self-rolling adhesive film deforms by itself from two end portions facing each other toward the center (usually, in the main contraction axis direction of the self-rolling adhesive film) to form two cylindrical shapes (bidirectional rolling). Note that, the self-rolling adhesive film, a substrate film formed of the self-rolling adhesive film provided with an adhesive layer have no significant difference in deformation into a cylindrical shape. Whether the self-rolling adhesive film rolls unidirectionally or bidirectionally is determined by e.g., the adhesive force of the rigid film to a thermal contraction film and Young's modulus or shearing storage elastic modulus of the rigid film (particularly, a bonding-agent layer).

In FIG. 4, reference symbol L indicates the length (diameter if the film is circular) of the film 1 or the adhesive film 5 in the rolling direction (usually, usually, in the main contraction axis direction of the thermal contraction film) (FIG. 4A). Reference symbol r indicates the diameter of the formed cylindrical shape (indicates the maximum diameter if the diameter of the cylindrical shape is not constant in the length direction, as is in the case where the film is circular) (FIG. 4C, D). In the film or adhesive film of the present invention, the r/L value indicates how compactly the adhesive film rolls. The r/L value preferably falls within the range of 0.0001 to 0.999 and further preferably within the range of 0.001 to 0.333.
Note that, reference symbol L is, for example, 10 to 2000 mm, and preferably 300 to 1000 mm. The length of the side of the film or adhesive film in perpendicular to the side indicated by reference symbol L, is for example, 10 to 2000 mm and preferably about 300 to 1000 mm. The r/L value can be set to fall within the aforementioned range by controlling the type of material, composition and thickness of each of the thermal contraction film 2, the rigid film 4, the bonding-agent layer 3 and the adhesive layer 6, in particular, the shearing storage elastic modulus and thickness of the bonding-agent layer 3 constituting the rigid film 4, and the Young's modulus and thickness of the rigid film 4. In this example, the shape of the film or adhesive film is a square; however, the shape is not limited to this and appropriately selected depending upon the purpose. More specifically, the shape may be any one of e.g., circular, ellipsoidal, polygonal shapes.

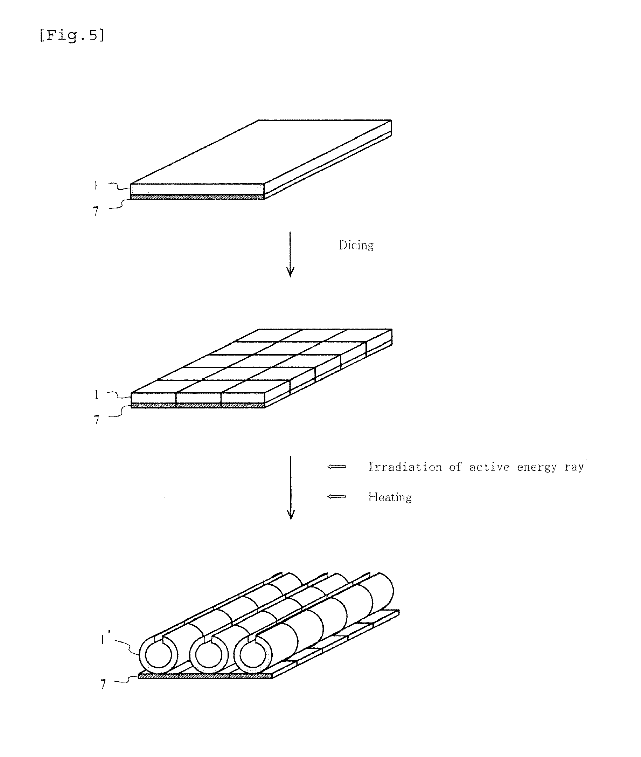

If a workpiece is processed by use of the adhesive film of the present invention, it is possible to avoid breakage of a workpiece by stress in detachment. More specifically, even if a fragile workpiece, such as a thin semiconductor wafer is processed, the adhesive film can be easily detached from the workpiece without breakage or contamination.
How to process is shown, for example, in FIG. 5. In the process shown in FIG. 5, the adhesive film of the present invention is bonded to a fragile surface of a workpiece. Thereafter, the workpiece is subjected to e.g., a dicing step. The adhesive film is detached from the workpiece by irradiation of e.g., active energy ray. The workpiece is further heated to contract the adhesive film cut together in the dicing step to deform the adhesive film into a cylindrical shape. Thereafter, from the surface of a workpiece, a cylindrically deformed adhesive film alone was removed to obtain a workpiece diced.

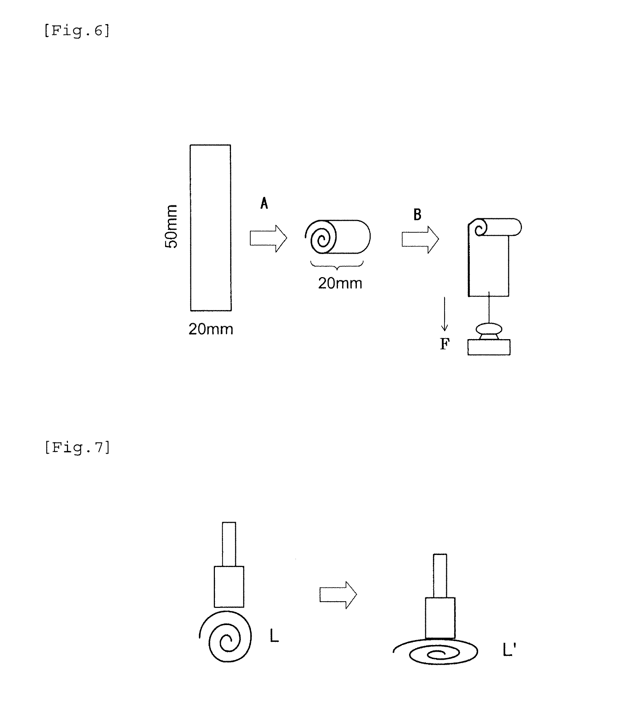

The present invention is directed to a film and an adhesive film formed of the aforementioned materials and layer structure and obtained by laminating a non-thermal contractive substrate on a thermal contraction film via a bonding-agent layer. Furthermore, the film needs to have the property of being not automatically returned to an original shape after the film is heated to form a cylindrical shape.
To confirm this property, the film is cut into pieces of 50 mm in length and 20 mm in width, as shown in FIG. 6. Each of the pieces is heated to obtain a cylindrical shape in step A. In step B, force F is applied to return the cylindrical shape into an original state (50 mm in length) before heating. If the force F exceeds 0.01 N, it can be determined that the cylindrical shape would not automatically return to an original shape.
The reason will be explained as follows. The cylindrical object acts as a spring. In order to return the cylindrical object to an original shape, force is required. The force varies depending upon the rigidity of the cylindrical object. More specifically, if the force required to return to an original shape exceeds 0.01 N, the film constituting the cylindrical object has high rigidity. Therefore, the film is bonded to a workpiece and then formed into a cylindrical object. Even if the stress produced in the operation of detaching and removing the cylindrical object acts so as to crush the cylindrical object, the crushed product is not deformed into a shape which facilitates rebonding to the workpiece. Even if the cylindrical object bonds again to the workpiece, deformation restoration occurs due to high rigidity (elasticity) and the rebonded portion is detached. In this manner, collection of cylindrical object can be simplified. Furthermore, if the force is 0.05 N or more, a further rigid cylindrical object can be formed.
Note that, in the above, the size of the film is defined to be 50 mm in length and 20 mm in width. The size of the film is not limited to this. This is described just as an example.
Needless to say, if the size of the film differs, the required force varies depending upon the size of the film and the force required for returning a shape to obtain an original length before heating is different from 0.01 N.

As a physical property required for the film of the present invention required in order for the film of a cylindrical shape not to automatically return to original shape, a product of Young's modulus and thickness of the thermal contraction film may be 42000 N/m or more and further preferably 80000 N/m or more. This is because in order to serve as a strong spring, the materials constituting a laminated resin layer must have high rigidity.
As to the Young's modulus of the thermal contraction film, the following should be noted. Since the thermal contraction film is generally prepared by biaxial drawing, the film has in-plane anisotropy, which means that Young's modulus differs between in the length direction and the width direction of the film. Of Young's modulus values of the both directions, a higher value can be employed in the present invention.

Furthermore, as shown in FIG. 7, the film is cut into pieces of a size of 10 × 10 mm and heated to obtain cylindrical objects. Then a load is added to each of the cylindrical objects. If the load required for reducing the diameter (L) of an initial object to a diameter (L') after the load is applied, which is 1/2 of L, is 1 N or more, it means that the cylindrical object has a strong resistance to external stress and has sufficient hardness in detaching and removing it. Furthermore, if the force is 1.2 N or more, it can be said that the cylindrical object has more sufficient hardness in detaching and removing it.

Hereinafter, the effect of the present invention will be described based on Examples.

### Examples

### (Manufacturing Example of Separator 1)

To one of the surfaces of 50 µm-thick PET film "Lumirror S10" manufactured by Toray Industries Inc., a release agent prepared from heptane-diluted 1% silicone (trade name: release agent "KS-774" manufactured by Shin-Etsu Chemical Co. Ltd. and catalysts "CAT PLR-1", "PLR-2" and "CAT PL-50T") was applied by a gravure coater, dried to obtain separator 1. The arithmetic average roughness Ra of the release-agent coated surface was 0.03 µm.

### (Manufacturing Example of Separator 2)

One of the surfaces of 50 µm-thick PET film "Lumirror S10" manufactured by Toray Industries Inc., was subjected to a treatment with sand blast. To the treated surface, a release agent prepared from silicone (trade name: release agent "KS-774" manufactured by Shin-Etsu Chemical Co. Ltd. and catalysts "CAT PLR-1", "PLR-2" and "CAT PL-50T") was applied and dried to obtain separator 2. The arithmetic average roughness Ra of the release-agent coated surface was 0.12 µm.

### (Manufacturing Example of Separator 3)

One of the surfaces of 50 µm-thick PET film "Lumirror S10" manufactured by Toray Industries Inc., was subjected to a treatment with sand blast. To the treated surface, a release agent prepared from silicone (trade name: release agent "KS-774" manufactured by Shin-Etsu Chemical Co. Ltd. and catalysts "CAT PLR-1", "PLR-2" and "CAT PL-50T") was applied and dried to obtain separator 3. The arithmetic average roughness Ra of the release-agent coated surface was 0.27 µm.

### (Manufacturing Example of Separator 4)

One of the surfaces of 50 µm-thick PET film "Lumirror S10" manufactured by Toray Industries Inc., was subjected to a treatment with sand blast. To the treated surface, a release agent prepared from silicone (trade name: release agent "KS-774" manufactured by Shin-Etsu Chemical Co. Ltd. and catalysts "CAT PLR-1", "PLR-2" and "CAT PL-50T") was applied and dried to obtain separator 4. The arithmetic average roughness Ra of the release-agent coated surface was 0.3 µm.

### (Manufacturing Example of Separator 5)

One of the surfaces of 50 µm-thick PET film "Lumirror S10" manufactured by Toray Industries Inc., was subjected to a treatment with sand blast. The treated surface was coated with a release agent prepared from silicone (trade name: release agent "KS-774" manufactured by Shin-Etsu Chemical Co. Ltd. and catalysts "CAT PLR-1", "PLR-2" and "CAT PL-50T") and dried to obtain separator 5. The release-agent coated surface has an arithmetic average roughness Ra of 0.36 µm.

### (Manufacturing Example of Separator 6)

A film of 15 µm in thickness formed of PE (polyethylene), a film of 60 µm in thickness formed of PP (polypropylene) and a film of 15 µm in thickness formed of PE (polyethylene) were laminated in this order to obtain separator 6 having a total thickness of 90 µm.
More specifically, low-density polyethylene (PE) (F522N manufactured by Ube Industries, Ltd.) was melted by use of two extruders respectively for an inner layer (A) and an outer layer (A). Furthermore, a composition (CAP355 manufactured by Ube Industries, Ltd.) of an amorphous polyolefin and a crystalline polypropylene (PP) was melted by use of another extruder for an intermediate layer (B). These melted materials were laminated by fusion in a single T-die of 250°C in the order of (A)/(B)/(A) and then extruded from the T-die, drawn by use of a draw roll in which warm water of 70°C was allowed to flow and equipped with an air knife (roll surface was 6s pearskin finish) in a draw ratio of 2.5 to obtain a film having a total thickness of 90 µm formed of the inner layer (A) and the outer layer (A) each having a thickness of 15 µm and the intermediate layer (B) of 60 µm. The surface of the outer layer (A) was embossed and the inner layer (A) was polished. The polished surface was used as a release surface.
The release surface has an arithmetic average roughness Ra of 0.16 µm.

### (Manufacturing Example of Separator 7)

To one of the surfaces of high quality paper "NSWF101-78" manufactured by Oji Specialty Paper Co., Ltd. was treated with corona. To the treated surface, low-density polyethylene "Suntech-LD L4490" manufactured by Asahi Kasei Chemicals Corporation was extruded and molded. The polyethylene surface was coated with a silicone release agent ("Silicolease AST-6A" and "Silicolease AST-6B") manufactured by Arakawa Chemical Industries Ltd. and dried to obtain separator 7. The release-agent coated surface had an arithmetic average roughness Ra of 0.69 µm.

### (Manufacturing Example of Separator 8)

One of the surfaces of 50 µm-thick PET film "Lumirror S10" manufactured by Toray Industries Inc., was coated with a release agent prepared from heptane-diluted 0.2% silicone (trade name: release agent "KS-3703" manufactured by Shin-Etsu Chemical Co. Ltd. and catalyst "CAT PL-50T") by a gravure coater and dried to obtain separator 8. The release-agent coated surface had an arithmetic average roughness Ra of 0.04 µm.

### (Manufacturing Example of Separator 9)

To one of the surfaces of Unbleached kraft paper "Kraft CPK" manufactured by Oji Specialty Paper Co., Ltd. was treated with corona. To the treated surface, a low-density polyethylene "Suntech-LD L4490" manufactured by Asahi Kasei Chemicals Corporation was extruded and molded. The polyethylene surface was coated with a silicone release agent ("KNS-3001" and "CAT-PL-56") manufactured by Shin-Etsu Chemical Co. Ltd. and dried to obtain a separator 9. The release-agent coated surface had an arithmetic average roughness Ra of 1.45 µm.

### (Manufacturing Example of Separator 10)

One of the surfaces of 50 µm-thick PET film "Lumirror S10" manufactured by Toray Industries Inc., was coated with a release agent prepared from heptane-diluted 0.04% silicone (trade name: release agent "KS-774" manufactured by Shin-Etsu Chemical Co. Ltd. and catalysts "CAT PLR-1", "PLR-2" and "CAT PL-50T") by a gravure coater and dried to obtain separator 10. The release-agent coated surface had an arithmetic average roughness Ra of 0.03 µm.

### (Production Example of Adhesive)

### Adhesive 1

From a toluene solution of a mixture (100 parts by weight) containing 2-ethylhexyl acrylate and 2-hydroxyethyl acrylate in a weight ratio of 90: 10, to which a polymerization initiator, benzyl peroxide (0.2 parts by weight) was added, an acrylic polymer (weight average molecular weight: 700,000) was obtained by copolymerization.
To the obtained acrylic polymer, 2-isocyanatoethyl methacrylate (trade name :Karenz MOI manufactured by SHOWA DENKO K. K.) containing a hydroxyl group derived from 2-hydroxyethyl acrylate in an amount of 50 mole % and dibutyltin dilaurate in an amount of 0.03 parts by weight relative to the acrylic polymer (100 parts by weight) were blended and reacted under air at 50°C for 24 hours to produce an acrylic polymer having a methacrylate group in the side chain.
To the obtained acrylic polymer (100 parts by weight), a radical photopolymerization initiator (IRGACURE 651, 2,2-dimethoxy-1,2-diphenylethan-1-one, manufactured by BASF)(1 part by weight) and an isocyanate compound (trade name, CORONATE L, manufactured by Nippon Polyurethane Industry Co., Ltd.)(1.5 parts by weight) were added to obtain UV curable adhesive 1.

### Adhesive 2

From a toluene solution of a mixture (100 parts by weight) containing ethyl acrylate, 2-ethylhexyl acrylate, methyl methacrylate and 2-hydroxyethyl acrylate in a weight ratio of 70: 30: 5: 4, to which a polymerization initiator, benzyl peroxide (0.2 parts by weight) was added, an acrylic polymer (weight average molecular weight: 480,000) was obtained by copolymerization.
To the obtained acrylic polymer (100 parts by weight), an isocyanate compound (trade name, CORONATE L, manufactured by Nippon Polyurethane Industry Co., Ltd.)(2 parts by weight) and a tin catalyst (trade name, EMBILIZER OL-1, manufactured by Tokyo Fine Chemical CO., LTD.)(0.025 parts by weight) were added to obtain non-UV curable adhesive 2.

### Adhesive 3

From an ethyl acetate solution of a mixture (100 parts by weight) containing butyl acrylate and acrylic acid in a weight ratio of 100: 5, to which a polymerization initiator, benzyl peroxide (0.2 parts by weight) was added, an acrylic polymer (weight average molecular weight: 1,250,000) was obtained by copolymerization.
To the obtained acrylic polymer (100 parts by weight), an isocyanate compound (trade name, CORONATE L, manufactured by Nippon Polyurethane Industry Co., Ltd.)(2 parts by weight) and an epoxy compound (trade name TETRAD-C, manufactured by Mitsubishi Gas Chemical Company Inc.)(0.5 parts by weight) were added to obtain non-UV curable adhesive 3.

### Adhesive 4

From an ethyl acetate solution of a mixture (100 parts by weight) containing ethyl acrylate, butyl acrylate, acrylic acid and 2-hydroxyethyl acrylate in a weight ratio of 30:70:5:1, to which a polymerization initiator, 2,2'-azobisisobutyronitrile (0.2 parts by weight) was added, an acrylic polymer (weight average molecular weight: 1,000,000) was obtained by copolymerization.
To the obtained acrylic polymer (100 parts by weight), an isocyanate compound (trade name, CORONATE L, manufactured by Nippon Polyurethane Industry Co., Ltd.)(2 parts by weight) and an epoxy compound (trade name TETRAD-C, manufactured by Mitsubishi Gas Chemical Company Inc.)(0.5 parts by weight) were added to obtain non-UV curable adhesive 4.

### Adhesive 5

From an ethyl acetate solution of a mixture (100 parts by weight) containing methyl acrylate, 2-ethylhexyl acrylate and acrylic acid in a weight ratio of 70:30:10, to which a polymerization initiator, benzoyl peroxide (0.2 parts by weight) was added, an acrylic polymer (weight average molecular weight: 830,000) was obtained by copolymerization.
To the obtained acrylic polymer (100 parts by weight), an isocyanate crosslinking agent (trade name, CORONATE, manufactured by Nippon Polyurethane Industry Co., Ltd.)(3 parts by weight), an epoxy crosslinking agent (trade name TETRAD-C, manufactured by Mitsubishi Gas Chemical Company Inc.)(0.75 parts by weight), a multifunctional urethane acrylate oligomer (trade name KAYARAD DPHA-40H manufactured by Nippon Kayaku Co., Ltd.,) (50 parts by weight) and a photopolymerization initiator (trade name "IRGACURE 651" manufactured by BASF)(3 parts by weight) were added to obtain UV curable adhesive 5.

### (Production Example of film for self-rolling adhesive film)

As a rigid film, a polyethylene terephthalate (PET) film (Lumilar S105 (thickness: 38 µm) manufactured by Toray Industries Inc., one of the surfaces was treated with corona) was used.
The surface of the rigid film layer treated with corona was coated with NB300 (containing a light blue pigment, manufactured by Dainichiseika Color & Chemicals, Mfg. Co., Ltd.,) so as to have a thickness (dry basis) of 1 to 2 µm by a gravure coater and dried to obtain a rigid film provided with an organic coating layer.
The surface of the rigid film layer opposite to the organic coating layer and the corona treated surface of a thermal contraction polyester film (Space clean S7200 of 30 µm in film thickness, one of the surfaces was treated with corona, manufactured by Toyobo Co., Ltd.) were bonded with a bonding agent by a dry laminate method to prepare a self-rolling tape substrate.
Note that the bonding agent used in dry laminate was prepared by blending Takerak A520, Takenate A10 (manufactured by Mitsui Chemicals, Inc.) and ethyl acetate in a weight ratio of 6:1:5.5. Furthermore, the thickness of the bonding agent (dry basis) was 2 to 4 µm.

### (Examples of self-rolling adhesive film)

### Example 1

A UV curable adhesive mixture obtained in a production example of an adhesive was applied to the release-agent coated surface of separator 1 by a die coater so as to obtain a film thickness (dry basis) of 30 µm. Thereafter, the resultant separator was bonded to the organic coating layer of the film for a self-rolling adhesive film to obtain self-rolling adhesive film 1. Note that, the adhesive was dried at 70°C in advance and then dried at 120°C.

### Example 2

Self-rolling adhesive film 2 was obtained in the same manner as in Example 1 except that separator 2 was used in place of separator 1.

### Example 3

Self-rolling adhesive film 3 was obtained in the same manner as in Example 1 except that separator 3 was used in place of separator 1.

### Example 4

Self-rolling adhesive film 4 was obtained in the same manner as in Example 1 except that separator 4 was used in place of separator 1.

### Example 5

Self-rolling adhesive film 5 was obtained in the same manner as in Example 1 except that separator 5 was used in place of separator 1.

### Example 6

Self-rolling adhesive film 6 was obtained in the same manner as in Example 1 except that separator 6 was used in place of separator 1.

### Example 7

Self-rolling adhesive film 7 was obtained in the same manner as in Example 1 except that separator 7 was used in place of separator 1.

### Example 8

Self-rolling adhesive film 8 was obtained in the same manner as in Example 1 except that separator 8 was used in place of separator 1.

### Example 9

Self-rolling adhesive film 9 was obtained in the same manner as in Example 1 except that non-UV curable adhesive 2 was used in place of UV curable adhesive 1.

### Example 10

Self-rolling adhesive film 10 was obtained in the same manner as in Example 1 except that non-UV curable adhesive 3 was used in place of UV curable adhesive 1.

### Example 11

Self-rolling adhesive film 11 was obtained in the same manner as in Example 1 except that non-UV curable adhesive 4 was used in place of UV curable adhesive 1.

### Example 12

Self-rolling adhesive film 12 was obtained in the same manner as in Example 1 except that UV curable adhesive 5 was used in place of UV curable adhesive 1.

### Comparative Example 1

Self-rolling adhesive film 13 was obtained in the same manner as in Example 1 except that separator 9 was used in place of separator 1.

### Comparative Example 2

Self-rolling adhesive film 14 was obtained in the same manner as in Example 1 except drying in advance.

### Comparative Example 3

Self-rolling adhesive film 15 was obtained in the same manner as in Example 1 except that separator 10 was used in place of separator 1.

### [Measurement of surface roughness]

Arithmetic average roughness Ra values of the adhesive layer surface and separator release-surface were measured by a contact type surface roughness meter or a non-contact type surface roughness meter in accordance with the types of the materials.
Contact type surface roughness meter: "P-15" manufactured by KLA-Tencor
Measurement length = 1000 µm
Measurement rate = 10 µm/second
Needle pressure = 5 mg
Non-contact type surface roughness meter: "Wyko NT9100" manufactured by Veeco
Measurement mode = VSI
Objective lens = 50 X or 10 X (magnification) Interior lens = 1.0 X (magnification)
Measurement area = 0.5 mm × 0.5 mm (using Stitching function)

### [Remaining glue after detachment]

Self-rolling adhesive films obtained in Examples and Comparative Examples were each bonded to the mirror surface of a silicon wafer having a 4-inch clean surface by a hand roller having own weight of 2 kg and allowed to stand at a 23°C atmosphere for 60 minutes. Thereafter, the substrate of the adhesive tape was irradiated with UV at an irradiation rate of 150 mJ/cm² by a UV irradiator (UM810 manufactured by NITTO SEIKI CO., Ltd.) to harden the adhesive layer.
Next, the mirror surface of the wafer after detachment by rolling was placed on a hot plate of 100°C and measured by a particle checker (Surfscan 6200 manufactured by KLA-Tencor). The number of particles having a diameter of 0.28 µm or more was counted and determined as the amount of remaining glue.
The case where 1000 particles or less remained was evaluated as ○; and the case where more than 1000 particles remained was evaluated as ×.
Note that, the samples prepared likewise in the aforementioned manner was subjected to peel detachment by hand at room temperature and then the number of particles were counted.

### [Peeling after dicing]

Self-rolling adhesive films obtained in Examples and Comparative Examples were each bonded to the mirror surface of a silicon wafer having a 4-inch clean surface by a hand roller having own weight of 2 kg and allowed to stand at a 23°C atmosphere for 60 minutes. Thereafter, the surface of the adhesive tape, more specifically, the surface by 5 mm inside from the outer periphery of the wafer was irradiated with UV at an irradiation rate of 150 mJ/cm² by a UV irradiator (UM810 manufactured by NITTO SEIKI CO., Ltd.) to harden the adhesive. Next, the wafer with a dicing tape "DU300" (manufactured by NITTO DENKO CORPORATION) was mounted on a dicing ring and diced by a dicer (DFD6450, manufactured by DISCO Corporation) into pieces of 10 mm × 10 mm in size.
After dicing, dicing lines were observed by a laser microscope (VK8510, magnification 50X, manufactured by KEYENCE CORPORATION). The case where air bubbles of 5 µm or more in diameter were observed in the vicinity of a dicing line was evaluated as ×, and the case where no air bubbles are generated or if air bubbles are generated but they have a diameter of 5 µm or less was evaluated as ○.

### [Measurement of r/L value]

The self-rolling adhesive films obtained in Examples and Comparative Examples were each cut into pieces of 100 × 100 mm. The self-rolling adhesive film using UV curable adhesive was irradiated with UV at a rate of about 500 mJ/cm².
An end of the adhesive sheet was soaked in warm water of 80°C along the contraction axis of the contraction film to facilitate deformation.
The diameter (r) of a cylindrical roll if obtained was measured by a ruler. The value (r) was divided by L (100 mm) to obtain r/L.

### [Determination of Young's modulus (80°C) of rigid film layer]

The Young's modulus of a rigid film layer was determined by the following method in accordance with JIS K7127. As a tensile tester, autograph AG-1kNG (equipped with warming hood) manufactured by Shimadzu Corporation. The rigid film was cut into test pieces (rigid film) of 200 mm in length × 10 mm in width. Each of the test pieces (rigid film) was provided between chucks having a distance of 100 mm. After the temperature of the ambient atmosphere was increased by the warming hood to 80°C, the test piece was pulled at a tension rate of 5 mm/minute to obtain distortion values. From the measurement values, a stress-distortion correlation was obtained. At two points showing distortion values of 0.2% and 0.45%, loads were read out to obtain Young's modulus. The measurement of a test piece was repeated 5 times and an average value thereof was employed.

### [Measurement of detachment force between thermal contraction film and rigid film]

The films for a self-rolling adhesive film obtained in Manufacturing Examples were cut into pieces of 70 mm in length × 10 mm in width. The surface of the rigid film layer (on the side of organic coating layer) and a silicon wafer serving as a rigid support substrate were bonded with a double-faced adhesive tape (trade name No. 5000N manufactured by NITTO DENKO CORPORATION). The bonded product was placed on a warmed stage of 70°C such that the rigid support substrate was in contact with the stage.

The surface of the contractive film layer and a pulling jig of a peel detachment tester were connected with an adhesive film so as to obtain a peel angle of 180°.
The pulling jig was pulled lengthwise at a tension rate of 300 mm/minute. The force (N/10 mm) was measured at the time the contractive film layer detached from the bonding-agent layer.

### [Measurement of detachment force of the separator]

Self-rolling adhesive films obtained in Examples or Comparative Examples were each cut into pieces of 120 mm in length × 50 mm in width.
The thermal contraction film of a self-rolling adhesive film piece and a silicon wafer serving as a rigid support substrate were bonded with a double-faced adhesive tape (trade name No. 5000N manufactured by NITTO

### DENKO CORPORATION).

The surface to which a separator release agent was not applied and a pulling jig of a peel detachment tester were connected with an adhesive film so as to obtain a peel angle of 180°.
The pulling jig was pulled lengthwise at a tension rate of 300 mm/minute under a room-temperature (about 23°C) atmosphere. The force (N/50 mm) was measured at the time the separator detached from the adhesive layer.

**[Table 1]**

| | Example 1 | Example 2 | Example 3 | Example 4 | Example 5 | Example 6 | Example 7 | Example 8 |
|---|---|---|---|---|---|---|---|---|
| Type of adhesive | Adhesive 1 | Adhesive 1 | Adhesive 1 | Adhesive 1 | Adhesive 1 | Adhesive 1 | Adhesive 1 | Adhesive 1 |
| Rigid-film thickness (µm) | 38 | 38 | 38 | 38 | 38 | 38 | 38 | 38 |
| Rigid-film Young's modulus (80°C) (GPa) | 3.72 | 3.72 | 3.72 | 3.72 | 3.72 | 3.72 | 3.72 | 3.72 |
| Rigid-film Young's modulus × thickness (N/m) | 141000 | 141000 | 141000 | 141000 | 141000 | 141000 | 141000 | 141000 |
| Detachment force between thermal contraction film and rigid film (70°C)(N/10mm) | 4.3 | 4.3 | 4.3 | 43 | 4.3 | 4.3 | 4.3 | 4.3 |
| Type of separator | Separator 1 | Separator 2 | Separator 3 | Separator 4 | Separator 5 | Separator 6 | Separator 7 | Separator 8 |
| Separator Ra (µm) | 0.03 | 0.12 | 0.27 | 0.3 | 0.36 | 0.16 | 0.69 | 0.04 |
| Detachment force of separator (N/50 mm) | 0.08 | 0.08 | 0.08 | 0.09 | 0.1 | 0.9 | 0.09 | 0.68 |
| Drying condition of adhesive (presence or absence of preparatory drying) | Presence | Presence | Presence | Presence | Presence | Presence | Presence | Presence |
| Ra of adhesive layer surface Ra (µm) | 0.02 | 0.12 | 0.27 | 0.31 | 0.35 | 0.18 | 0.65 | 0.11 |
| r value (mm) | 4.5 | 5 | 5 | 5 | 4.5 | 5 | 5 | 5 |
| r/L | 0.045 | 0.05 | 0.05 | 0.05 | 0.045 | 0.05 | 0.05 | 0.05 |
| Surfacing after dicing (diameter of air bubbles in the vicinity of line is 5 µm or less is ○) | ○ | ○ | ○ | ○ | ○ | ○ | ○ | ○ |
| Remaining glue after rolling (1000 particles or less particles/4 inch wafer is indicated by ○) | 11 | 20 | 447 | 482 | 725 | 216 | 897 | 31 |
| Remaining glue after manual peel-detachment (particles/4 inch wafer) | 12 | 22 | 413 | 466 | 587 | 234 | 822 | 38 |
| Judgment = (pass: both results of surfacing after dicing and remaining glue after rolling are ○) | Pass | Pass | Pass | Pass | Pass | Pass | Pass | Pass |

**[Table 2]**

| | Example 9 | Example 10 | Example 11 | Example 12 | Comparative Example 1 | Comparative Example 2 | Comparative Example 3 |
|---|---|---|---|---|---|---|---|
| Type of adhesive | Adhesive 2 | Adhesive 3 | Adhesive 4 | Adhesive 5 | Adhesive 1 | Adhesive 1 | Adhesive 1 |
| Rigid-film thickness (µm) | 38 | 38 | 38 | 38 | 38 | 38 | 38 |
| Rigid-film Young's modulus (80°C) (GPa) | 3.72 | 3.72 | 3.72 | 3.72 | 3.72 | 3.72 | 3.72 |
| Rigid-film Young's modulus × thickness (N/m) | 141000 | 141000 | 141000 | 141000 | 141000 | 141000 | 141000 |
| Detachment force between thermal contraction film and rigid film (70°C) (N/10mm) | 4.3 | 4.3 | 4.3 | 4.3 | 4.3 | 4.3 | 4.3 |
| Type of separator | Separator 1 | Separator 1 | Separator 1 | Separator 1 | Separator 9 | Separator 1 | Separator 10 |
| Separator Ra (µm) | 0.03 | 0.03 | 0.03 | 0.03 | 1.45 | 0.03 | 0.03 |
| Detachment force of separator (N/50 mm) | 0.1 | 0.08 | 0.08 | 0.11 | 0.13 | 0.08 | 1.15 |
| Drying condition of adhesive (presence or absence of preparatory drying) | Presence | Presence | Presence | Presence | Presence | Presence | Presence |
| Ra of adhesive layer surface Ra (µm) | 0.03 | 0.03 | 0.04 | 0.03 | 1.55 | 2.88 | 1.12 |
| r value (mm) | 5 | 5 | 5 | 4.5 | 4.5 | 4.5 | 4.5 |
| r/L | 0.05 | 0.05 | 0.05 | 0.45 | 0.045 | 0.045 | 0.045 |
| Surfacing after dicing (diameter of air bubbles in the vicinity of line is 5 µm or less is ○) | ○ | ○ | ○ | ○ | × | × | × |
| Remaining glue after rolling (1000 particles or less particles/4 inch wafer is indicated by ○) | 258 | 387 | 567 | 16 | 14464 | 5843 | 2879 |
| Remaining glue after manual peel-detachment (particles/4 inch wafer) | 72 | 892 | 1171 | 13 | 916 | 4877 | 1985 |
| Judgment (pass: both results of surfacing after dicing and remaining glue after rolling are ○) | Pass | Pass | Pass | Pass | Failed | Failed | Failed |

From the results of Examples 1 to 12 and Comparative Examples 1 to 3, it can be confirmed that Ra (1.0 µm or less) of an adhesive layer has significant effect upon adhesion to a workpiece. Particularly in Comparative Example 1, the remaining glue (expressed in terms of particle number) significantly differs between self-rolling detachment and peel-detachment. From this, it is found that Ra of adhesive layer surface is important to effectively use the self-rolling detachment.
Furthermore, it is found that, in order to reduce Ra of the adhesive layer surface to 1.0 µm or less, Ra of the separator (Comparative Example 1) and detachment force of the separator (Comparative Example 3) are important, and that adhesive coating conditions (Comparative Example 2) may also serve as a regulatory factor.

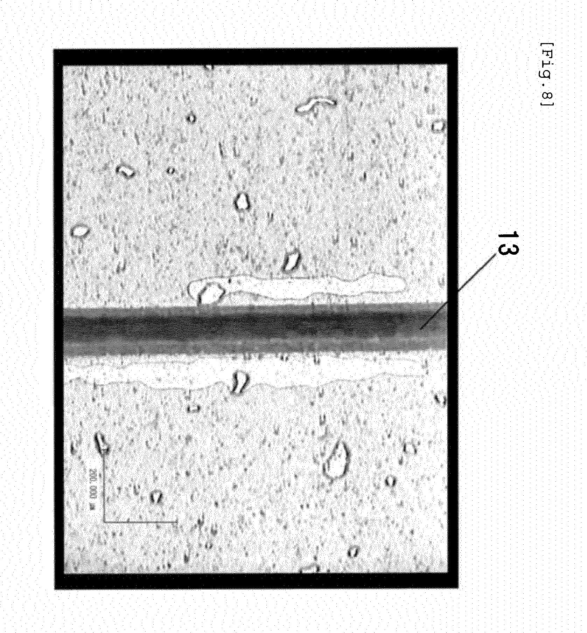

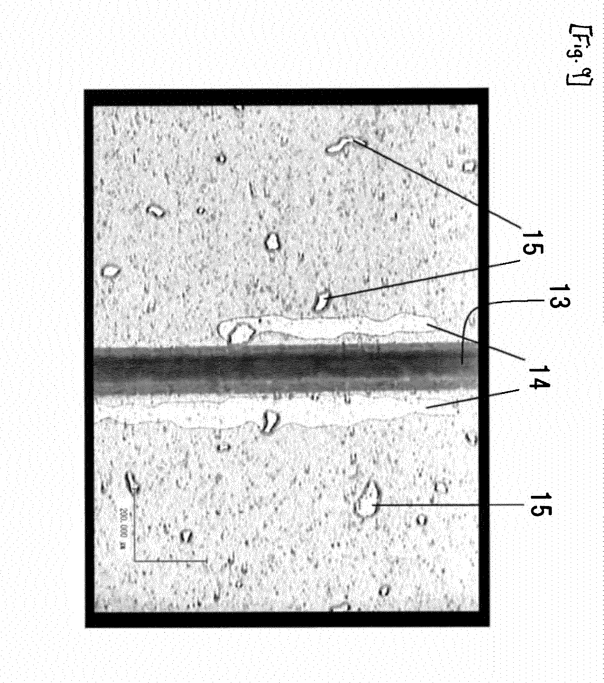

Detachment of a self-rolling adhesive film from a wafer after dicing is shown in FIGS. 8 and 9.
As shown in FIG. 8, in the case of using the self-rolling adhesive film of Example 1, no air bubbles are observed after dicing between a wafer and an adhesive layer even near a cutting site 13, and a trace showing that water penetrated from the cutting site in dicing is not observed.
In contrast, as shown in FIG. 9, in the case of using the self-rolling adhesive film of Comparative Example 1, air bubbles 15 are observed after dicing in many sites except a cutting site 13. Air bubbles are produced at the time the self-rolling adhesive film was bonded to a wafer before dicing. Furthermore, in the self-rolling adhesive film bonding portion near the cutting site 13, water penetration site 14 is clearly observed.

- 1: Film
- 2: Thermal contraction film
- 3: Bonding-agent layer
- 4: Rigid film
- 5: Adhesive film
- 6: Adhesive layer
- 7: Workpiece
- 8: Double-faced film
- 10: Contact point
- 11: Support plate
- 12: Support plate
- 13: Cutting site
- 14: Water penetration site
- 15: Air bubbles
- P: Separator

## Claims

1. A self-rolling adhesive film comprising a multi-layered substrate comprising a thermal contraction film, an adhesive layer and a separator, wherein the surface of the adhesive layer after detachment of the separator has an arithmetic average roughness Ra of 1.0 µm or less.

2. The self-rolling adhesive film according to Claim 1, wherein a detachment surface of the separator has an arithmetic average roughness Ra of 1.0 µm or less and a detachment force of the separator is 1.0 N/50 mm or less.

3. The self-rolling adhesive film according to Claim 1, wherein the thermal contraction film has a contraction percentage of 30 to 90% in a main contraction direction at a predetermined temperature within the range of 70 to 180°C.

4. The self-rolling adhesive film according to Claim 1, wherein the multi-layered substrate comprises a rigid film and the rigid film has a product obtained by multiplying Young's modulus at 80°C and a thickness thereof of 3.0 × 10⁵ N/m or less.

5. The self-rolling adhesive film according to Claim 4, wherein the thermal contraction film has a contraction percentage of 30 to 90% in a main contraction direction at a predetermined temperature within the range of 70 to 180°C and a product obtained by multiplying Young's modulus of the rigid film at 80°C and a thickness thereof is 3.0 × 10⁵ N/m or less.

6. The self-rolling adhesive film according to any one of Claims 1 to 5, obtained by sequentially laminating the thermal contraction film, the bonding-agent layer, the rigid film, the adhesive layer and the separator in this order.

7. The self-rolling adhesive film according to any one of Claims 1 to 5, obtained by providing the adhesive layer on the separator and thereafter bonding the adhesive layer to the multi-layered substrate.

8. The self-rolling adhesive film according to any one of Claims 1 to 5, wherein an organic coating layer is provided between the rigid film and the adhesive layer.

9. The self-rolling adhesive film according to any one of Claims 1 to 5, wherein the adhesive layer is energy-ray curable or pressure-sensitive.

10. The self-rolling adhesive film according to any one of Claims 1 to 5, wherein detachment force (180° detachment by peeling, tension rate: 300 mm/minute) required for detachment between the thermal contraction film layer and the rigid film layer at 70°C is 2.0 N/10 mm or more.

11. A method for processing a workpiece, comprising
bonding the self-rolling adhesive film according to any one of Claims 1 to 10 to a workpiece,
cutting the workpiece into small pieces, and heating to roll the self-rolling adhesive film, thereby detaching the self-rolling adhesive film from the workpiece.

12. The processing method according to Claim 11, wherein the workpiece is a semiconductor wafer or a protecting member for an optical device.
